# EUROPEAN PATENT APPLICATION

(11) **EP 4 794 468 A1**
(43) Date of publication of application: **19.08.2026**
(21) Application number: 26156675.6
(22) Date of filing: 05.02.2026
(51) Int. Cl.: H10B 12/00, H10D 30/67, H10D 30/01

(54) **SEMICONDUCTOR MEMORY DEVICE**

(30) Priority: 13.02.2025 KR 20250018791
(71) Applicant: Samsung Electronics Co., Ltd., Suwon-si, Gyeonggi-do 16677 (KR)
(72) Inventor: LEE, Jungha, 16677 Suwon-si (KR); KIM, Seokwon, 16677 Suwon-si (KR); LEE, Sunjung, 16677 Suwon-si (KR); LEE, Dosun, 16677 Suwon-si (KR)
(74) Representative: Marks & Clerk LLP

(57) **Abstract**

A semiconductor memory device includes a stack structure including a plurality of layers stacked on a substrate in a vertical direction, and bit lines disposed at a side of the stack structure and extending in the vertical direction. The plurality of layers include semiconductor patterns, gate electrodes extending from the semiconductor patterns in a first horizontal direction, and information storage elements adjacent to the semiconductor patterns in a second horizontal direction crossing the first horizontal direction. The semiconductor patterns include first impurity regions adjacent to the bit lines, second impurity regions adjacent to the information storage elements, and channel regions between the first impurity regions and the second impurity regions. The information storage elements include first electrodes adjacent to the second impurity regions. A portion of the stack structure includes metal silicides disposed between the second impurity regions at a side of the semiconductor patterns and the first electrodes.

## Description

### BACKGROUND

The present disclosure relates generally to semiconductor memory devices, and more particularly, to a semiconductor memory device capable of enhancing electrical characteristics.

When memory cells of a semiconductor memory device are arranged two-dimensionally or planarly, the integration of the semiconductor memory device may be determined by an area occupied by a unit memory cell and thus may be significantly affected by a level of fine pattern formation technology.

However, equipment that may be needed to refine patterns may be considerably costly, which may limit increases in the integration of the semiconductor memory device implemented two-dimensionally or planarly. As a result, semiconductor memory devices having three-dimensionally arranged memory cells may have been proposed.

### SUMMARY

One or more example embodiments of the present disclosure provide a semiconductor memory device having enhanced electrical characteristics, when compared to related semiconductor memory devices.

The technical aspects to be addressed by the present disclosure are not limited to the technical aspects mentioned above, and other technical aspects not mentioned may be clearly understood by those skilled in the art from the description of the present disclosure.

According to an aspect of the present disclosure, a semiconductor memory device includes a stack structure including a plurality of layers stacked on a substrate in a vertical direction, and bit lines disposed at a side of the stack structure and extending in the vertical direction. The stack structure includes a first stack structure on the substrate and a second stack structure on the first stack structure. The plurality of layers include semiconductor patterns, gate electrodes extending from the semiconductor patterns in a first horizontal direction, and information storage elements adjacent to the semiconductor patterns in a second horizontal direction crossing the first horizontal direction. The semiconductor patterns include first impurity regions adjacent to the bit lines, second impurity regions adjacent to the information storage elements, and channel regions between the first impurity regions and the second impurity regions. The information storage elements include first electrodes adjacent to the second impurity regions. One of the first stack structure and the second stack structure includes metal silicides disposed between the second impurity regions at a side of the semiconductor patterns and the first electrodes.

According to an aspect of the present disclosure, a semiconductor memory device includes a stack structure including a plurality of layers stacked on a substrate in a vertical direction, and bit lines disposed at one side of the stack structure and extending in the vertical direction. The stack structure includes a first stack structure on the substrate and a second stack structure on the first stack structure. The plurality of layers include semiconductor patterns, gate electrodes extending from the semiconductor patterns in a first horizontal direction, and information storage elements adjacent to the semiconductor patterns in a second horizontal direction crossing the first horizontal direction. The semiconductor patterns include first impurity regions adjacent to the bit lines, second impurity regions adjacent to the information storage elements, and channel regions between the first impurity regions and the second impurity regions. The information storage elements include first electrodes adjacent to the second impurity regions. The first stack structure includes an active stack structure including metal silicides disposed between the second impurity regions at one side of the semiconductor patterns and the first electrodes. The second stack structure includes a dummy stack structure in which the metal silicides are not disposed.

According to an aspect of the present disclosure, a semiconductor memory device includes a stack structure including a plurality of layers stacked on a substrate in a vertical direction, bit lines disposed at one side of the stack structure and extending in the vertical direction, and spacers extending in a first horizontal direction. The stack structure includes a first stack structure on the substrate and a second stack structure on the first stack structure. The plurality of layers include semiconductor patterns, gate electrodes extending from the semiconductor patterns in the first horizontal direction, and information storage elements adjacent to the semiconductor patterns in a second horizontal direction crossing the first horizontal direction. The semiconductor patterns include first impurity regions adjacent to the bit lines, second impurity regions adjacent to the information storage elements, and channel regions between the first impurity regions and the second impurity regions. The information storage elements include first electrodes adjacent to the second impurity regions. The spacers are disposed at a side of the gate electrodes in the second horizontal direction and disposed between the second impurity regions in the vertical direction. The first stack structure includes a dummy stack structure in which metal silicides are not disposed. The second stack structure includes an active stack structure including metal silicides disposed between the second impurity regions at a side of the semiconductor patterns and the first electrodes.

Additional aspects may be set forth in part in the description which follows and, in part, may be apparent from the description, and/or may be learned by practice of the presented embodiments.

At least some of the above and other features of the invention are set out in the claims.

### BRIEF DESCRIPTION OF THE DRAWINGS

The above and other aspects, features, and advantages of certain embodiments of the present disclosure may be more apparent from the following description taken in conjunction with the accompanying drawings in which:
FIG. 1 is a schematic circuit diagram illustrating a cell array of a semiconductor memory device, according to an embodiment;
FIGS. 2 to 5 are perspective views illustrating sub-cell arrays of a semiconductor memory device, according to an embodiment;
FIG. 6 is a cross-sectional view of a semiconductor memory device, according to an embodiment;
FIG. 7 is an enlarged cross-sectional views of portion CX1 of FIG. 6, according to an embodiment;
FIG. 8 is an enlarged cross-sectional view of portion CX2 of FIG. 6, according to an embodiment;
FIGS. 9 to 16 are cross-sectional views illustrating a method of manufacturing the semiconductor memory device of FIGS. 6 to 8, according to an embodiment;
FIG. 17 is a cross-sectional view of a semiconductor memory device, according to an embodiment;
FIG. 18 is a plan view of a memory module including a semiconductor memory device, according to an embodiment;
FIG. 19 is a schematic diagram of a memory card including a semiconductor device, according to an embodiment; and
FIG. 20 is a schematic diagram of a system including a semiconductor memory device, according to an embodiment.

### DETAILED DESCRIPTION OF THE EMBODIMENTS

Hereinafter, example embodiments of the present disclosure are described with reference to the accompanying drawings. The following embodiments of the present disclosure may be implemented as only one, and the following embodiments may be implemented by combining one or more. Thus, the technical idea of the present disclosure may not be limited to one embodiment.

The following description with reference to the accompanying drawings is provided to assist in a comprehensive understanding of embodiments of the present disclosure defined by the claims. Various specific details are included to assist in understanding, but these details are considered to be examples only. Therefore, those of ordinary skill in the art may recognize that various changes and modifications of the embodiments described herein may be made without departing from the scope of the disclosure. In addition, descriptions of well-known functions and structures are omitted for clarity and conciseness.

In the present disclosure, the singular forms of the components may include a plurality of forms, unless the context clearly dictates otherwise. In the present disclosure, the present disclosure is exaggerated to more clearly describe the present disclosure. With regard to the description of the drawings, similar reference numerals may be used to refer to similar or related elements.

Although, in the present disclosure, the terms "first", "second", or the like may be used for the description of various components or elements, these components or elements may not be limited by these terms. These terms may only be used to distinguish one element or component from another. Accordingly, it may be apparent that a first element or component may also be a second element or component within the technical aspects of the present disclosure.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower", and the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", and the like may be used to distinguish components from each other and do not limit the present disclosure. For example, the terms "first", "second", "third", and the like may not necessarily involve an order or a numerical meaning of any form.

As used herein, when an element or layer is referred to as "covering", "overlapping", or "surrounding" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

As used herein, each of the terms "AlO", "BaSrTiO", "BaTiO", "CoSi", "HfO", "HfSiO", "LaO", "LiO", "MoSi", "PbScTaO", "PbZnNb", "SiN", "SiO", "SiON", "SrTiO", "TaN", "TaO", "TiN", "TiO", "TiSi", "WSi", "ZrO", "ZrSi", "ZrSiO", or the like may refer to a material made of elements included in each of the terms and is not a chemical formula representing a stoichiometric relationship.

Hereinafter, various embodiments of the present disclosure are described with reference to the accompanying drawings.

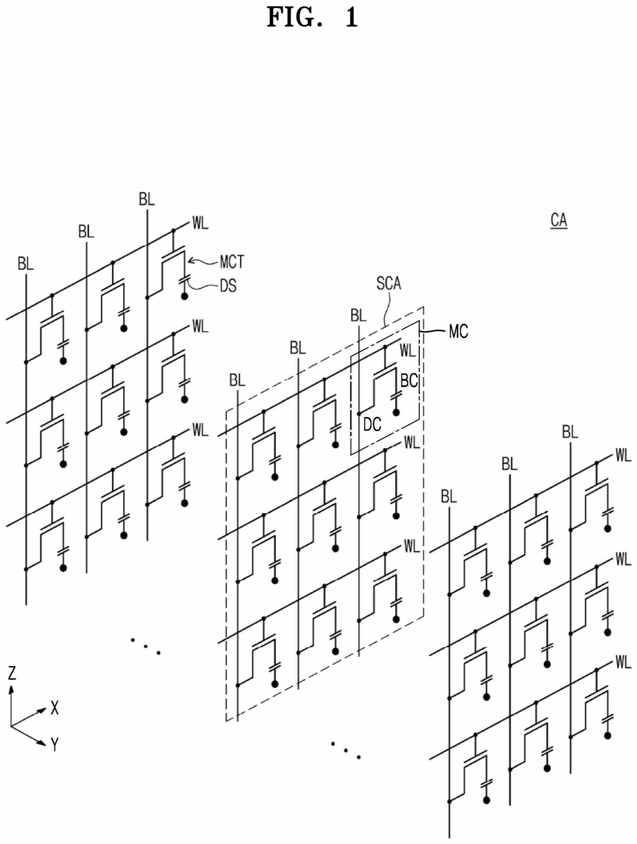

FIG. 1 is a schematic circuit diagram illustrating a cell array of a semiconductor memory device, according to an embodiment.

Referring to FIG. 1, a cell array CA of the semiconductor memory device, according to an embodiment, may include a plurality of sub-cell arrays SCA. The cell array CA of the semiconductor memory device may include three-dimensionally arranged memory cells MC. The semiconductor memory device, according to the present disclosure, may be and/or may include a three-dimensional (3D) semiconductor memory device.

The plurality of sub-cell arrays SCA may be arranged in a second horizontal direction (e.g., Y direction). Each of the sub-cell arrays SCA may include a plurality of bit lines BL, a plurality of word lines WL, and a plurality of memory cell transistors MCT. In an embodiment, one memory cell transistor MCT may be arranged between one word line WL and one bit line BL.

The bit lines BL may be and/or may include conductive patterns (e.g., metal lines) that may extend in a direction (e.g., vertical or Z direction) perpendicular to a substrate. The bit lines BL in one sub-cell array SCA may be spaced apart from each other in a first horizontal direction (e.g., X direction) and may be arranged. Adjacent bit lines BL may be spaced apart from each other in the first horizontal direction (e.g., X direction).

The word lines WL may be and/or may include conductive patterns (e.g., metal lines) stacked on the substrate in the vertical direction (e.g., Z direction). Each of the word lines WL may extend in the first horizontal direction (e.g., X direction). Adjacent word lines WL may be spaced apart from each other in the vertical direction (e.g., Z direction).

A gate electrode of the memory cell transistor MCT may be connected to the word line WL, and a first source/drain of the memory cell transistor MCT may be connected to the bit lines BL via a direct contact DC.

A second source/drain of the memory cell transistor MCT may be connected to information (or data) storage element DS via a buried contact BC. For example, the information (or data) storage element DS may be and/or may include a capacitor. The second source/drain of the memory cell transistor MCT may be connected to a first electrode of the information storage element DS (e.g., the capacitor).

The bit lines BL, the word lines WL, the memory cell transistor MCT, and the information storage element DS included in each of the sub-cell arrays SCA may constitute a memory cell MC.

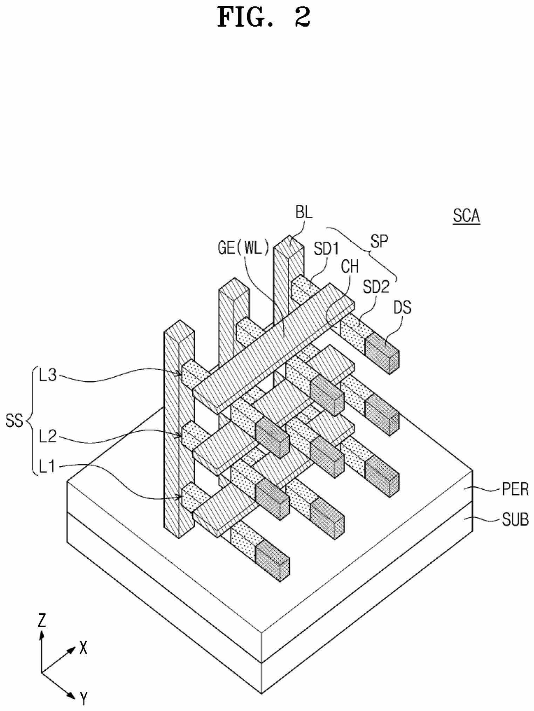

FIGS. 2 to 5 are perspective views illustrating sub-cell arrays of a semiconductor memory device, according to an embodiment.

Referring to FIG 2, a peripheral circuit region PER may be provided on a substrate SUB. The substrate SUB may be and/or may include a silicon (Si) substrate, a germanium (Ge) substrate, or a silicon-germanium (Si-Ge) substrate. The peripheral circuit region PER may include peripheral transistors provided on the substrate SUB. For example, the peripheral circuit region PER may include a circuit for operating the cell array CA, according to embodiments.

One of the plurality of sub-cell arrays SCA may be provided on the peripheral circuit region PER. For example, a stack structure SS including a plurality of layers (e.g., a first layer L1, a second layer L2, and a third layer L3) may be provided on the peripheral circuit region PER. The first to third layers L1 to L3 of the stack structure SS may be spaced apart from each other in a direction perpendicular to the substrate SUB (e.g., a vertical or Z direction) and may be stacked. Each of the first to third layers L1 to L3 may include a plurality of semiconductor patterns SP, a plurality of information storage elements DS, and a gate electrode GE.

The semiconductor patterns SP may have a line shape and/or bar shape that may extend in a second horizontal direction (e.g., Y direction). The semiconductor patterns SP may include a semiconductor material such as, but not limited to, silicon (Si), germanium (Ge), or silicon-germanium (Si-Ge). For example, the semiconductor patterns SP may include, but not be limited to, polysilicon, monocrystalline silicon, or the like.

Each of the semiconductor patterns SP may include a channel region CH, a first impurity region SD1, and a second impurity region SD2. The channel region CH may be between the first impurity region SD1 and the second impurity region SD2. The channel region CH may correspond to a channel of the memory cell transistor MCT. The first impurity region SD1 and the second impurity region SD2 may correspond to the first source/drain and the second source/drain of the memory cell transistor MCT.

The first impurity region SD1 and the second impurity region SD2 may be and/or may include regions doped with impurities in the semiconductor patterns SP. The first impurity region SD1 and the second impurity region SD2 may be and/or may include regions doped with impurities having an n-type and/or a p-type conductivity. The first impurity region SD1 may be formed adjacent to a first end of the channel region CH, and the second impurity region SD2 may be formed adjacent to a second end of the channel region CH. The second end may face the first end in the second horizontal direction (e.g., Y direction).

The information storage elements DS may be respectively connected to the semiconductor patterns SP. That is, the information storage elements DS may be respectively connected to the second impurity region SD2 of the semiconductor patterns SP. The information storage elements DS may be and/or may include memory elements in which data may be stored. For example, the information storage elements DS may be and/or may include capacitors.

Gate electrodes GE may have a line shape and/or a bar shape that may extend in the first horizontal direction (e.g., X direction). The gate electrodes GE may be spaced apart from each other in the vertical direction (e.g., Z direction) and stacked. Each of the gate electrodes GE may intersect the semiconductor patterns SP in one layer and may extend in the first horizontal direction (e.g., X direction). That is, the gate electrodes GE may include and/or may be similar in many respects to the horizontal word lines WL described above with reference to FIG. 1. The gate electrodes GE may include a conductive material.

For example, the conductive material may be and/or may include one of a doped semiconductor material (e.g., doped silicon, doped germanium, or the like), a conductive metal nitride (e.g., titanium nitride (TiN), tantalum nitride (TaN), or the like), a metal (e.g., tungsten (W), titanium (Ti), tantalum (Ta), or the like), or a metal-semiconductor compound (e.g., tungsten silicide (WSi), cobalt silicide (CoSi), titanium silicide (TiSi), or the like).

The plurality of bit lines BL that extend in a direction perpendicular to the substrate SUB (e.g., vertical or Z direction) may be provided. Each of the bit lines BL may have a line shape and/or a pillar shape that may extend in the vertical direction (e.g., Z direction). The bit lines BL may be arranged in the first horizontal direction (e.g., X direction). Each of the bit lines BL may be electrically connected to the first impurity regions SD1 of the vertically stacked semiconductor patterns SP.

The bit lines BL may include a conductive material such as, but not limited to, a doped semiconductor material, a conductive metal nitride, a metal, a metal-semiconductor compound, or the like. The bit lines BL may include and/or may be similar in many respects to the vertical bit lines BL described above with reference to FIG. 1.

The first layer L1 from among the first to third layers L1 to L3 is described as a representative example. The semiconductor patterns SP of the first layer L1 may be arranged in the first horizontal direction (e.g., X direction). The semiconductor patterns SP of the first layer L1 may be positioned at a substantially similar and/or the same level. The gate electrodes GE of the first layer L1 may intersect the semiconductor patterns SP in the first layer L1 and may extend in the first horizontal direction (e.g., X direction). For example, the gate electrodes GE of the first layer L1 may be provided on upper surfaces of the semiconductor patterns SP.

A gate insulating layer may be disposed between the gate electrodes GE and the channel region CH. The gate insulating layer may include at least one of a high dielectric layer, a silicon oxide (SiO) layer, a silicon nitride (SiN) layer, a silicon oxynitride (SiON) layer, or the like.

For example, the high dielectric layer may include at least one of hafnium oxide (HfO), hafnium silicon oxide (HfSiO), lanthanum oxide (LaO), zirconium oxide (ZrO), zirconium silicon oxide (ZrSiO), tantalum oxide (TaO), titanium oxide (TiO), barium strontium titanium oxide (BaSrTiO), barium titanium oxide (BaTiO), strontium titanium oxide (SrTiO), lithium oxide (LiO), aluminum oxide (AlO), lead scandium tantalum oxide (PbScTaO), lead zinc niobate (PbZnNb), or the like.

Each of the bit lines BL may be connected to the first end of the semiconductor pattern SP of the first layer L1. For example, the bit lines BL may be directly connected to first impurity regions SD1. As another example, the bit lines BL may be electrically connected to the first impurity region SD1 via a metal silicide. The second layer L2 and the third layer L3 may be substantially similar and/or the same as the first layer L1 described above. Consequently, repeated descriptions of the second layer L2 and the third layer L3 described above with reference to the first layer L1 may be omitted for the sake of brevity.

Empty spaces in the stack structure SS may be filled with an insulating material. For example, the gate insulating layer may include at least one of a silicon oxide (SiO) layer, a silicon nitride (SiN) layer, a silicon oxynitride (SiON) layer, or the like. A wiring layer electrically connected to the sub-cell array SCA may be provided on the stack structure SS. The wiring layer may be electrically connected to the peripheral circuit region PER via a through contact.

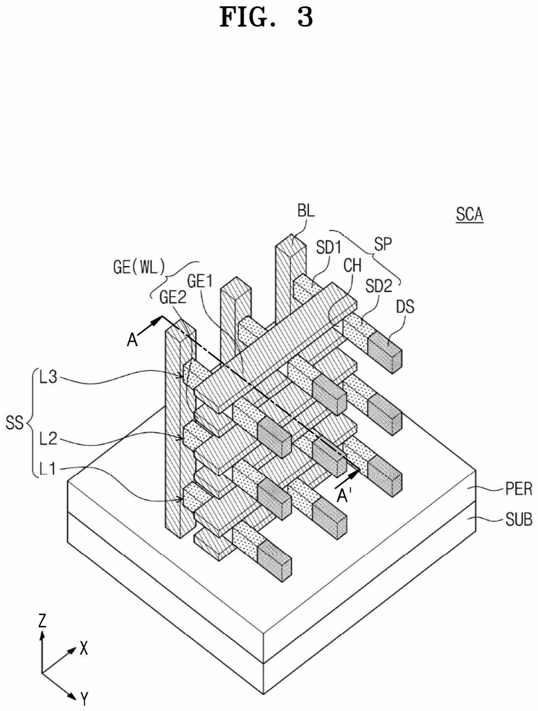

The embodiments illustrated in FIGS. 3 to 5 may include and/or may be similar in many respects to the embodiments described above with reference to FIGS. 1 and 2, and may include additional features not mentioned above. Consequently, repeated descriptions of FIGS. 3 to 5 described above with reference to FIGS. 1 and 2 may be omitted for the sake of brevity, and differences between the embodiments of FIGS. 3 to 5 and FIGS. 1 and 2 are described.

Referring to FIGS. 1 and 3, the gate electrode GE may include a first gate electrode GE1 on an upper surface of a semiconductor pattern SP, and a second gate electrode GE2 on a bottom surface of the semiconductor pattern SP. That is, a memory cell transistor, according to an embodiment, may be and/or may include a double gate transistor in which the gate electrode GE may be provided on both surfaces of a channel region CH.

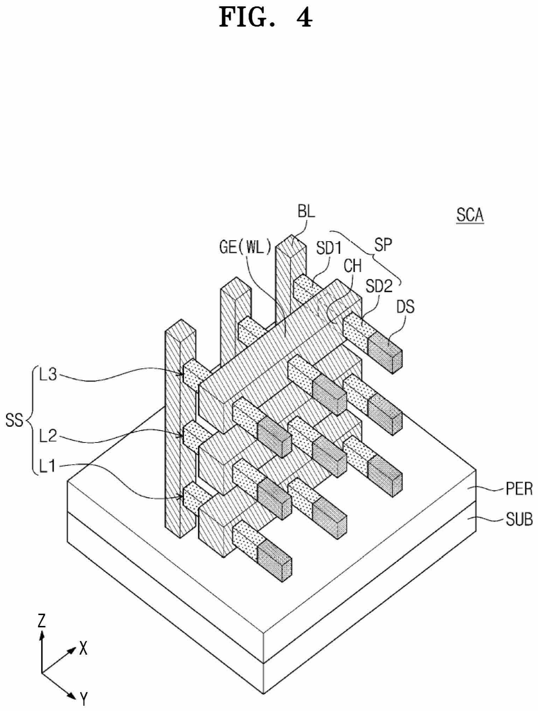

Referring to FIGS. 1 and 4, the gate electrode GE may surround the channel region CH of the semiconductor pattern SP. The gate electrode GE may be provided on an upper surface, a bottom surface, and both sidewalls of the channel region CH. That is, the memory cell transistor, according to an embodiment, may be and/or may include a gate all-around transistor in which the gate electrode GE surrounds the channel region CH.

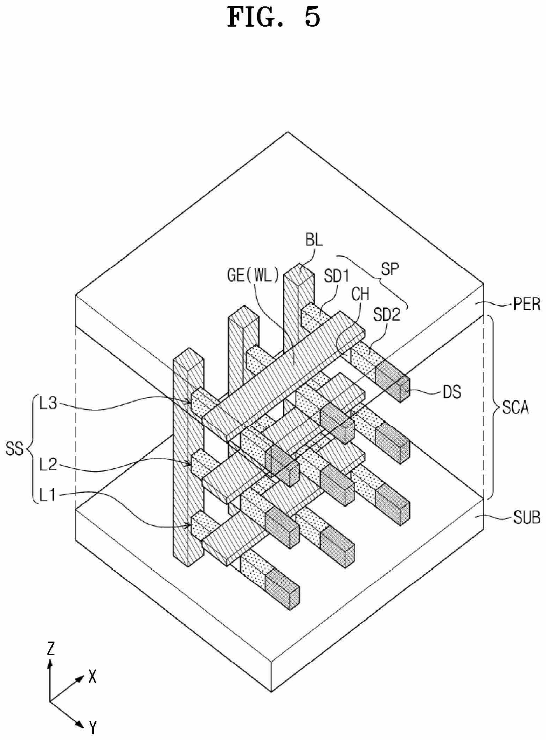

Referring to FIGS. 1 and 5, the sub-cell array SCA may be provided on the substrate SUB. The peripheral circuit region PER may be provided on the sub-cell array SCA. As described above with reference to FIGS. 1 and 2, the peripheral circuit region PER may include a circuit for operating the sub-cell array SCA.

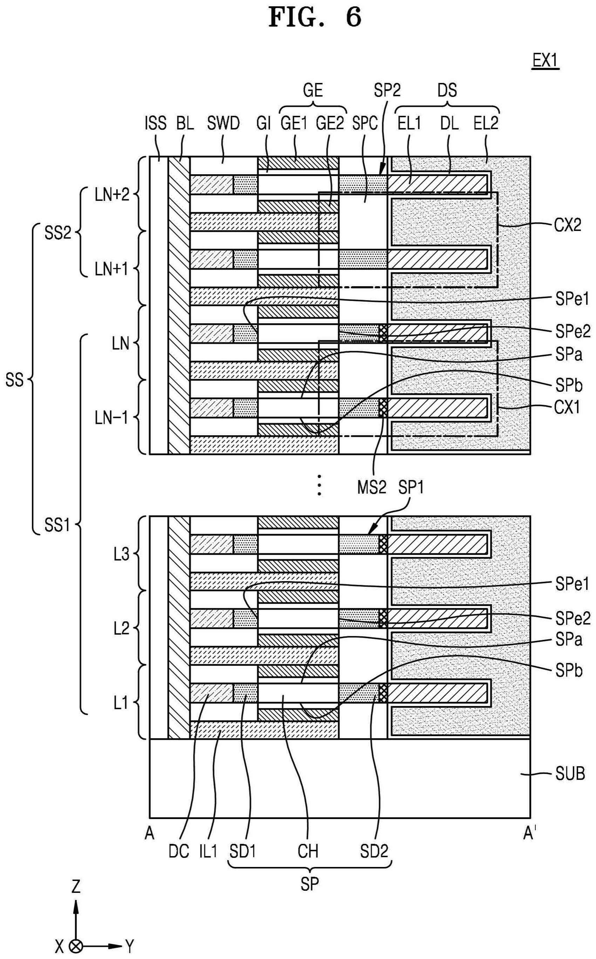

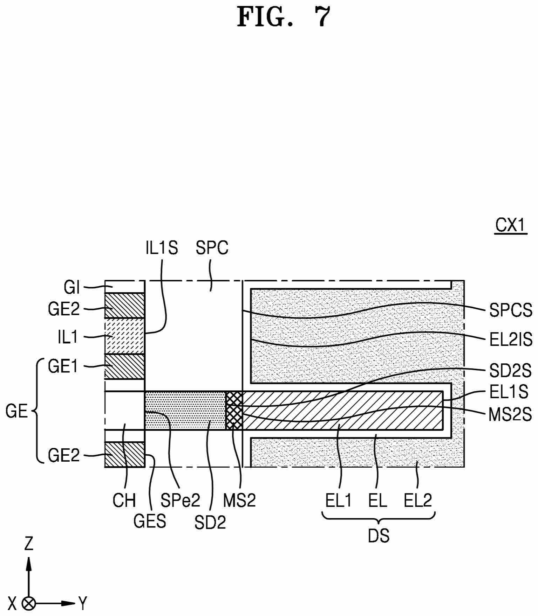

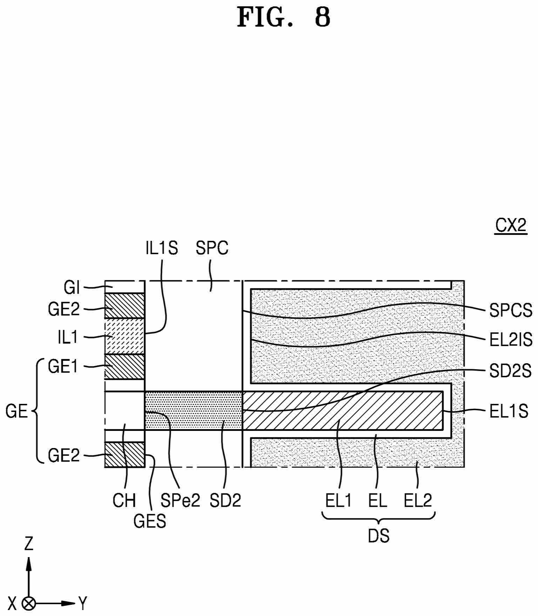

FIG. 6 is a cross-sectional view of a semiconductor memory device, according to an embodiment. FIG. 7 is enlarged cross-sectional view of portion CX1 of FIG. 6, according to an embodiment. FIG. 8 is an enlarged cross-sectional view of portion CX2 of FIG. 6, according to an embodiment.

Referring to FIG. 6, a semiconductor memory device EX1 may include a cross-sectional portion taken along a line A-A' of FIG. 3. The embodiments illustrated in FIGS. 6, 7, and 8 may include and/or may be similar in many respects to the embodiments described above with reference to FIGS. 1 and 3, and may include additional features not mentioned above. Consequently, repeated descriptions of FIGS. 6, 7, and 8 described above with reference to FIGS. 1 and 3 may be briefly described or omitted for the sake of brevity.

As shown in FIGS. 3 and 6, the stack structure SS may be provided on the substrate SUB. For example, the stack structure SS may be arranged together with the gate electrode GE in the second horizontal direction (e.g., Y direction). When the stack structure SS is provided in plural, a plurality of stack structures SS may be arranged in the first horizontal direction (e.g., X direction).

The stack structure SS may include a first stack structure SS1 formed on the substrate SUB and a second stack structure SS2 formed on the first stack structure SS1. The first stack structure SS1 may include a first plurality of layers (e.g., a first layer, L1, a second layer L2, a third layer L3, to an (N-1)-th layer LN-1, and an N-th layer LN, where N is a positive integer greater than one (1)) sequentially stacked on the substrate SUB.

In some embodiments, N may range between several tens and several hundreds. For example, N may range between 10 and 500. However, embodiments of the present disclosure are not limited in this regard. The first stack structure SS1 may be an active stack structure that may operate as the memory cell (e.g., memory cell MC of FIG. 1). The first stack structure SS1 may be and/or may include an active stack structure in which metal silicides MS2 may be arranged.

The second stack structure SS2 may include a second plurality of layers (e.g., a (N+1)-th layer LN+1 and a (N+2)-th layer LN+2), which may be sequentially stacked on the first stack structure SS1. The second stack structure SS2 may be and/or may include a dummy stack structure that may not operate as the memory cell MC. The second stack structure SS2 may be and/or may include a dummy stack structure in which the metal silicides MS2 are not arranged. The (N+1)-th layer LN+1 and the (N+2)-th layer LN+2, according to an embodiment, may be an example, and additional layers may be stacked on the (N+2)-th layer LN+2.

Each of the first to (N+2)-th layers L1 to LN+2 may include a first insulating layer IL1, a semiconductor pattern SP, a gate electrode GE, a sidewall insulating pattern SWD, and a spacer SPC. The semiconductor patterns SP formed in the first stack structure SS1 may include first semiconductor patterns SP1.

The semiconductor patterns SP formed in the second stack structure SS2 may include second semiconductor patterns SP2. A second stack number of the second semiconductor patterns SP2 formed in the second stack structure SS2 may be less than a first stack number of the first semiconductor patterns SP1 formed in the first stack structure SS1.

In some embodiments, the stack number of the first semiconductor patterns SP1 and the second semiconductor patterns SP2 may range between several tens and several hundreds. In some embodiments, the second stack number of the second semiconductor patterns SP2 may be 5% to 15% of the first stack number of the first semiconductor patterns SP1.

Each of the first to (N+2)-th layers L1 to LN+2 may further include a direct contact DC adjacent to the semiconductor pattern SP, and an information storage element DS. The semiconductor pattern SP, the gate electrode GE, and the sidewall insulating pattern SWD may be provided on a first insulating layer IL1. The first insulating layer IL1 may be configured to allow the gate electrode GE of an upper layer and the gate electrode GE of a lower layer to be spaced apart from each other in the vertical direction (e.g., Z direction).

The gate electrode GE may include at least one of a doped semiconductor material, a conductive metal nitride, metal, a metal-semiconductor compound, or the like. The semiconductor pattern SP may include a semiconductor material such as, but not limited to, silicon (Si), germanium (Ge), or silicon-germanium (Si-Ge). The first insulating layer IL1 may include at least one of a silicon oxide (SiO) layer, a silicon nitride (SiN) layer, a silicon oxynitride (SiON) layer, a carbon containing a silicon oxide (SiO) layer, a carbon containing a silicon nitride (SiN) layer, or a carbon containing a silicon oxynitride (SiON) layer.

The semiconductor pattern SP may include a channel region CH, a first impurity region SD1, and a second impurity region SD2. The channel region CH may have a first stage SPe1, and a second stage SPe2 facing the first stage SPe1 in the second horizontal direction (e.g., Y direction). The first impurity region SD1 may be arranged at one side of the first stage SPe1, and the second impurity region SD2 may be arranged at one side of the second stage SPe2. The first stage SPe1 may correspond to the first end described above with reference to FIG. 2. The second stage SPe2 may correspond to the second end described above with reference to FIG. 2.

In an embodiment, the first impurity region SD1 may be arranged between the channel region CH and the bit lines BL (e.g. adjacent to the bit lines BL). The second impurity region SD2 may be arranged between the channel region CH and the information storage element DS (e.g. adjacent to the information storage element DS). The channel region CH may be between the first impurity region SD1 and the second impurity region SD2.

In an embodiment, the channel region CH, the first impurity region SD1, and the second impurity region SD2 may be integrally configured. That is, a boundary between the channel region CH and the first impurity region SD1 and a boundary between the channel region CH and the second impurity region SD2 may not be observed.

The first impurity region SD1 and the second impurity region SD2 may be regions doped with impurities in the semiconductor patterns SP. For example, the first impurity region SD1 and the second impurity region SD2 may have an n-type or p-type conductivity.

The impurity doping concentration of the second impurity region SD2 may be increased as the second impurity region SD2 goes farther from the gate electrode GE in the second horizontal direction (e.g., Y direction). Alternatively, the impurity doping concentration of the second impurity region SD2 may be decreased as the second impurity region SD2 goes closer to the gate electrode GE in an opposite direction to the second horizontal direction (e.g., Y direction). The differences in impurity doping concentration may be a result of using a gas phase doping (GPD) process as a method of forming the second impurity region SD2.

For example, the impurity doping concentration of the second impurity region SD2, according to a distance from the gate electrode GE in the second horizontal direction (e.g., Y direction), may be constantly increased and/or exponentially increased. However, embodiments of the present disclosure are not limited thereto, and the impurity doping concentration of the second impurity region SD2, according to the distance from the gate electrode GE in the second horizontal direction (e.g., Y direction), may also be irregularly increased.

The gate electrode GE of each of the first to (N+2)-th layers L1 to LN+2 may include the first gate electrode GE1 on a first surface SPa of the semiconductor pattern SP, and the second gate electrode GE2 on a second surface SPb of the semiconductor pattern SP. The second surface SPb may face the first surface SPa in the vertical direction (e.g., Z direction). For example, the first surface SPa may be an upper surface of the semiconductor pattern SP, and the second surface SPb may be a bottom surface of the semiconductor pattern SP.

The first gate electrode GE1 and the second gate electrode GE2 may be vertically spaced apart from each other with the semiconductor pattern SP therebetween. That is, the semiconductor pattern SP may be sandwiched between the first gate electrode GE1 and the second gate electrode GE2 provided on and under the semiconductor pattern SP, respectively.

The first gate electrode GE1 and the second gate electrode GE2 may extend in parallel to each other in the first horizontal direction (e.g., X direction). For example, the gate electrode GE of each of the first to N-th layers L1 to LN may constitute one word line (e.g., word line WL of FIG. 1). The gate electrode GE, according to an embodiment, may continuously cross the semiconductor patterns SP arranged in the first horizontal direction (e.g., X direction) within one layer.

A gate insulating pattern GI may be disposed between the first gate electrode GE1, the second gate electrode GE2, and the semiconductor pattern SP. The gate insulating pattern GI may include one single layer of at least one of a high dielectric layer, a silicon oxide (SiO) layer, a silicon nitride (SiN) layer, a silicon oxynitride (SiON) layer, or a combination thereof.

A memory cell transistor, according to an embodiment, may have a double gate structure in which the first gate electrode GE1 and the second gate electrode GE2 are arranged on and under the semiconductor pattern SP, respectively. That is, the memory cell transistor, according to an embodiment, may be and/or may include a double gate transistor as described above with reference to FIG. 3. The memory cell transistor, according to an embodiment, may have a double gate structure so that the controllability of the gate electrode GE may be enhanced, when compared to related gate electrodes. The semiconductor patterns SP of each of the first to (N+2)-th layers L1 to LN+2 may be separated from each other by vertical insulators and arranged in the first horizontal direction (e.g., X direction).

In an embodiment, bit lines BL that penetrate the stack structure SS may be provided. The bit lines BL may be separated from each other by the vertical insulators. The bit lines BL may be arranged in the first horizontal direction (e.g., X direction). The bit lines BL may include and/or may be similar in many respects to the bit lines BL described above with reference to FIGS. 1 and 3.

The bit lines BL may be arranged at one side of the first stage SPel of the channel region CH. The direct contact DC may be arranged at one side of the first stage SPel of the channel region CH. The direct contact DC may be arranged between the bit lines BL and the first impurity region SD1. In one example, the bit lines BL may be disposed at a (e.g. one) side of the stack structure SS.

The bit lines BL may be connected to the direct contact DC. The bit lines BL may be electrically connected to the first impurity region SD1 via the direct contact DC. The direct contact DC may include, but not be limited to, a metal silicide.

In an embodiment, an insulating structure ISS that covers sidewalls of the bit lines BL may be provided. The insulating structure ISS may extend in the first horizontal direction (e.g., X direction). The insulating structure ISS may include at least one of a silicon oxide (SiO) layer, a silicon nitride (SiN) layer, a silicon oxynitride (SiON) layer, or the like.

The sidewall insulating pattern SWD may be arranged between the bit lines BL and the gate electrode GE. The sidewall insulating pattern SWD may be configured to electrically insulate the bit lines BL and the gate electrode GE from each other.

The sidewall insulating pattern SWD may be arranged on an upper surface and a lower surface of the first impurity region SD1. The sidewall insulating pattern SWD may be arranged on an upper surface and a lower surface of the direct contact DC. The sidewall insulating pattern SWD may be arranged on an upper surface and a lower surface of the first insulating layer IL1.

The information storage element DS may be arranged at one side of the second stage SPe2 of the channel region CH. The information storage element DS may be electrically connected to the second impurity region SD2. The information storage element DS may be in plural. Each of the information storage elements DS may include a first electrode EL1, a dielectric layer DL, and a second electrode EL2.

The information storage elements DS may share one dielectric layer DL and one second electrode EL2. That is, the first electrode EL1 may be provided in plural within the stack structure SS, and one dielectric layer DL may cover surfaces of the first electrodes EL1. One second electrode EL2 may be provided on one dielectric layer DL.

Each of the first electrodes EL1 may have a cylinder shape with filled interior. The second electrode EL2 may be provided on an outer surface of a cylinder of the first electrode EL1. The first electrodes EL1 may be respectively connected to the semiconductor patterns SP within one layer. That is, the first electrodes EL1 may be respectively connected to the second impurity region SD2 within one layer. The first electrodes EL1 within one layer may be arranged in the first horizontal direction (e.g., X direction).

In the first stack structure SS1, a metal silicide MS2 may be arranged between the first electrode EL1 and the second impurity region SD2. In the second stack structure SS2, the metal silicide MS2 may not be arranged between the first electrode EL1 and the second impurity region SD2. In some embodiments, the metal silicide MS2 may form a titanium silicide (TiSi), a cobalt silicide (CoSi), a molybdenum silicide (MoSi), a zirconium silicide (ZrSi), or the like.

The second electrode EL2 may include at least one of a metal material (e.g., titanium (Ti), tantalum (Ta), tungsten (W), copper (Cu), or aluminum (Al)), a conductive metal nitride (e.g., titanium nitride (TiN) or tantalum nitride (TaN)), a doped semiconductor material (e.g., doped silicon or doped germanium), or the like.

The dielectric layer DL may include a high dielectric constant material (e.g., hafnium oxide (HfO), hafnium silicon oxide (HfSiO), lanthanum oxide (LaO), zirconium oxide (ZrO), zirconium silicon oxide (ZrSiO), tantalum oxide (TaO), titanium oxide (TiO), barium strontium titanium oxide (BaSrTiO), barium titanium oxide (BaTiO), strontium titanium oxide (SrTiO), lithium oxide (LiO), aluminum oxide (AlO), lead scandium tantalum oxide (PbScTaO), and lead zinc niobate (PbZnNb), or a combination thereof).

A spacer SPC may be arranged between the second electrode EL2 and the gate electrode GE. The spacer SPC may be arranged between the second impurity region SD2 of an upper layer and the second impurity region SD2 of a lower layer. The spacer SPC may be configured to allow the second impurity region SD2 of the upper layer and the second impurity region SD2 of the lower layer to be spaced apart from each other in the vertical direction (e.g., Z direction).

Referring to FIG. 3 and FIGS. 6 to 8 together, an outer wall SPCS of the spacer SPC may be separated from an outer wall EL1S of a first electrode EL1. The outer wall SPCS of the spacer SPC may be a sidewall farther spaced apart from the bit lines BL among both sidewalls of the spacer SPC in the second horizontal direction (e.g., Y direction). Similarly, the outer wall EL1S of the first electrode EL1 may be a sidewall farther spaced apart from the bit lines BL among both sidewalls of the first electrode EL1 in the second horizontal direction (e.g., Y direction).

The outer wall EL1S of the first electrode EL1 may be farther spaced apart from the gate electrode GE than the outer wall SPCS of the spacer SPC in the second horizontal direction (e.g., Y direction). Alternatively, the outer wall EL1S of the first electrode EL1 may be farther spaced apart from the bit lines BL than the outer wall SPCS of the spacer SPC in the second horizontal direction (e.g., Y direction). That is, the outer wall SPCS of the spacer SPC may be more adjacent to the gate electrode GE than the outer wall EL1S of the first electrode EL1 in the second horizontal direction (e.g., Y direction). Alternatively, the outer wall SPCS of the spacer SPC may be more adjacent to the bit lines BL than the outer wall EL1S of the first electrode EL1 in the second horizontal direction (e.g., Y direction).

The outer wall SPCS of the spacer SPC may be spaced apart from an outer wall IL1S of the first insulating layer IL1. The outer wall IL1S of the first insulating layer IL1 may be a sidewall farther spaced apart from the bit lines BL among both sidewalls of the first insulating layer IL1 in the second horizontal direction (e.g., Y direction).

The outer wall SPCS of the spacer SPC may be farther spaced apart from the bit lines BL than the outer wall IL1S of the first insulating layer IL1 in the second horizontal direction (e.g., Y direction). The outer wall SPCS of the spacer SPC may be farther spaced apart from the gate electrode GE than the outer wall IL1S of the first insulating layer IL1 in the second horizontal direction (e.g., Y direction). That is, the outer wall IL1S of the first insulating layer IL1 may be more adjacent to the bit lines BL than the outer wall SPCS of the spacer SPC in the second horizontal direction (e.g., Y direction).

As shown in FIG. 7, the outer wall SPCS of the spacer SPC in the first stack structure SS1 may be aligned in a line with the outer wall MS2S of the metal silicide MS2. The outer wall SPCS of the spacer SPC may form a coplanar surface with the outer wall MS2S of the metal silicide MS2. The outer wall MS2S of the metal silicide MS2 may be a sidewall farther spaced apart from the bit line BL among both sidewalls of the metal silicide MS2 in the second horizontal direction (e.g., Y direction).

As shown in FIG. 8, in the second stack structure SS2, the outer wall SPCS of the spacer SPC may be aligned in a line with the outer wall SD2S of the second impurity region SD2. The outer wall SPCS of the spacer SPC may form a coplanar surface with the outer wall SD2S of the second impurity region SD2. The outer wall SD2S of the second impurity region SD2 may be a sidewall farther spaced apart from the bit lines BL among both sidewalls of the second impurity region SD2 in the second horizontal direction (e.g., Y direction).

The outer wall SPCS of the spacer SPC may be spaced apart from an outer wall GES of the gate electrode GE. The outer wall GES of the gate electrode GE may be a sidewall farther spaced apart from the bit lines BL among both sidewalls of the gate electrode GE in the second horizontal direction (e.g., Y direction). The outer wall SPCS of the spacer SPC may be farther spaced apart from the bit lines BL than the outer wall GES of the gate electrode GE in the second horizontal direction (e.g., Y direction). That is, the outer wall GES of the gate electrode GE may be more adjacent to the bit lines BL than the outer wall SPCS of the spacer SPC.

The spacer SPC may be spaced apart from the second electrode EL2 in the second horizontal direction (e.g., Y direction) with the dielectric layer DL therebetween. The outer wall SPCS of the spacer SPC may be spaced apart from the inner wall EL2IS of the second electrode EL2 with the dielectric layer DL therebetween. The inner wall EL2IS of the second electrode EL2 may be a sidewall closest to the gate electrode GE in the second horizontal direction (e.g., Y direction) among sidewalls of the second electrode EL2 in the second horizontal direction (e.g., Y direction).

The inner wall EL2IS of the second electrode EL2 may be more adjacent to the gate electrode GE in the second horizontal direction (e.g., Y direction) than the outer wall EL1S of the first electrode EL1. For example, the outer wall IL1S of the first insulating layer IL1 may be aligned in a line with the outer wall GES of the gate electrode GE. The outer wall IL1S of the first insulating layer IL1 may form a coplanar surface with the outer wall GES of the gate electrode GE.

As described above, in the semiconductor memory device EX1 of the present disclosure, the metal silicide MS2 may not be formed at one side of the second semiconductor patterns SP2 of an upper layer among the semiconductor patterns SP that constitute the stack structure SS vertically stacked on the substrate SUB. Furthermore, in the semiconductor memory device EX1 of the present disclosure, the metal silicide MS2 may be formed at one side of the first semiconductor patterns SP1 of a lower layer among the semiconductor patterns SP that constitute the stack structure SS vertically stacked on the substrate SUB.

That is, in the semiconductor memory device EX1 of the present disclosure, the metal silicide MS2 may not be formed between the second impurity region SD2 (e.g., a second source/drain) at one side of the second semiconductor patterns SP2 of an upper layer among the semiconductor patterns SP that constitute the stack structure SS, and the information storage element DS (e.g., a capacitor). Furthermore, in the semiconductor memory device EX1 of the present disclosure, the metal silicide MS2 may be formed between the second impurity region SD2 (e.g., a second source/drain) at one side of first semiconductor patterns SP1 of a lower layer among the semiconductor patterns SP that constitute the stack structure SS, and the information storage element DS (e.g., a capacitor).

In the semiconductor memory device EX1 of the present disclosure, the metal silicide MS2 may be formed only at one side of the first semiconductor patterns SP1 of a lower layer among the semiconductor patterns SP that constitute the stack structure SS, so that distribution of contact resistances between the first semiconductor patterns SP1 in the vertical direction (e.g., Z direction) during a manufacturing process may be reduced. Thus, in the semiconductor memory device EX1 of the present disclosure, distribution of contact resistances between memory cells may be reduced so that electrical characteristics of the semiconductor memory device EX1 may be enhanced, when compared to related semiconductor memory devices.

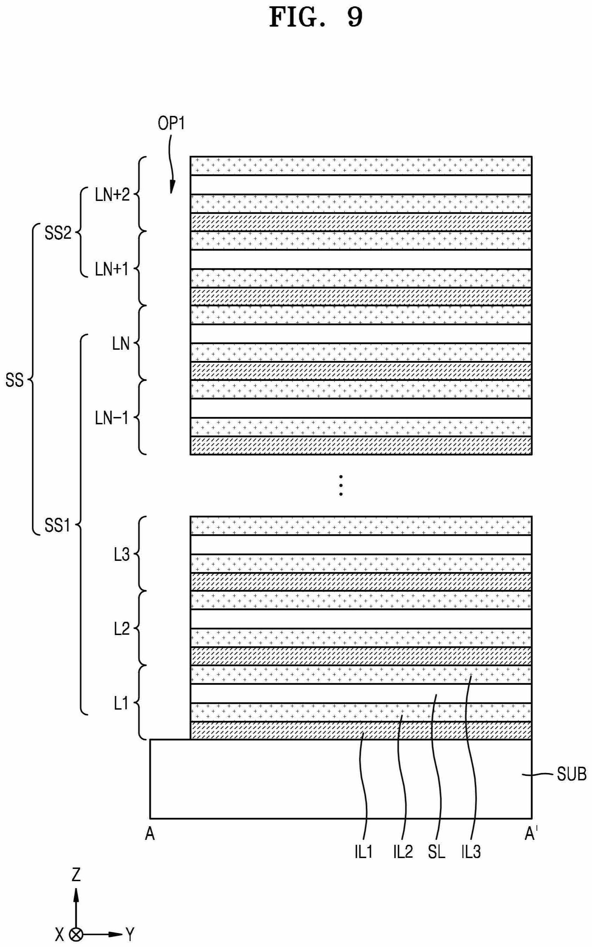

FIGS. 9 to 16 are cross-sectional views illustrating a method of manufacturing the semiconductor memory device of FIGS. 6 to 8.

In FIGS. 9 to 16, the same reference numerals as those of FIGS. 6 to 8 may represent similar and/or the same elements. Consequently, repeated descriptions of the FIGS. 9 to 16 described above with reference to FIGS. 6 to 8 may be briefly described or omitted for the sake of brevity.

Referring to FIG. 9, a stack structure SS may be formed on a substrate SUB.

The stack structure SS may include a first stack structure SS1 and a second stack structure SS2. The forming of the first stack structure SS1 may include forming of the first plurality of layers L1 to LN on the substrate SUB. The forming of the stack structure SS2 may include forming of the second plurality of layers LN+1 to LN+2 on the first stack structure SS1.

Each of forming of the first to N-th layers L1 to LN and the forming of the (N+1)-th layer and the (N+2)-th layer may include forming a first insulating layer IL1, forming a second insulating layer IL2 on the first insulating layer IL1, forming a semiconductor layer SL on the second insulating layer IL2, and forming a third insulating layer IL3 on the semiconductor layer SL.

That is, each of the first to N-th layers L1 to LN and the (N+1)-th layer and the (N+2)-th layer may include the first insulating layer IL1, the second insulating layer IL2, the semiconductor layer SL, and the third insulating layer IL3, which are sequentially stacked.

The first insulating layer IL1, the second insulating layer IL2, and the third insulating layer IL3 may include at least one of a silicon oxide (SiO) layer, a silicon nitride (SiN) layer, a silicon oxynitride (SiON) layer, a carbon containing a silicon oxide (SiO) layer, a carbon containing a silicon nitride (SiN) layer, and a carbon containing a silicon oxynitride (SiON) layer.

The second insulating layer IL2 and the third insulating layer IL3 may include the same material. The second insulating layer IL2 and the third insulating layer IL3 may include a material having etching selectivity with the first insulating layer IL1. For example, the first insulating layer IL1 may include a silicon oxide (SiO) layer, and the second insulating layer IL2 and the third insulating layer IL3 may include a silicon nitride (SiN) layer.

The semiconductor layer SL may include a semiconductor material such as, but not limited to, silicon (Si), germanium (Ge), or silicon-germanium (Si-Ge). Subsequently, a first opening OP1 that penetrates the stack structure SS is formed. The first opening OP1 may expose an upper surface of the substrate SUB.

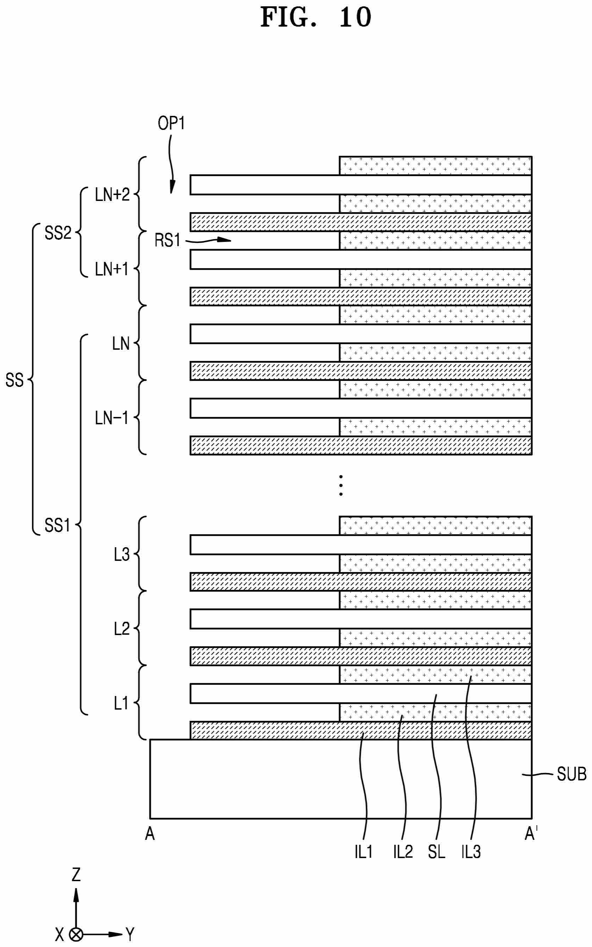

Referring to FIG. 10, the second insulating layer IL2 and the third insulating layer IL3 exposed by the first opening OP1 may be partially etched, so that a first recess RS1 may be formed.

In an embodiment, a wet etching process of selectively etching the second insulating layer IL2 and the third insulating layer IL3 through the first opening OP1 may be performed. During the wet etching process, the first insulating layers IL1 and the semiconductor layers SL may remain as they are. During the wet etching process, the second insulating layer IL2 and the third insulating layer IL3 may be partially etched, so that the first recesses RS1 may be formed. Each of the first recesses RS1 may be positioned at the same vertical level as the second insulating layers IL2 and the third insulating layers IL3.

Sidewalls of the second insulating layers IL2 and the third insulating layers IL3 may be exposed by the first recesses RS1. A part of an upper surface and a part of a lower surface of the semiconductor layer SL may be exposed by the first recesses RS1. A part of an upper surface and a part of a lower surface of the first insulating layer IL1 may be exposed by the first recesses RS1.

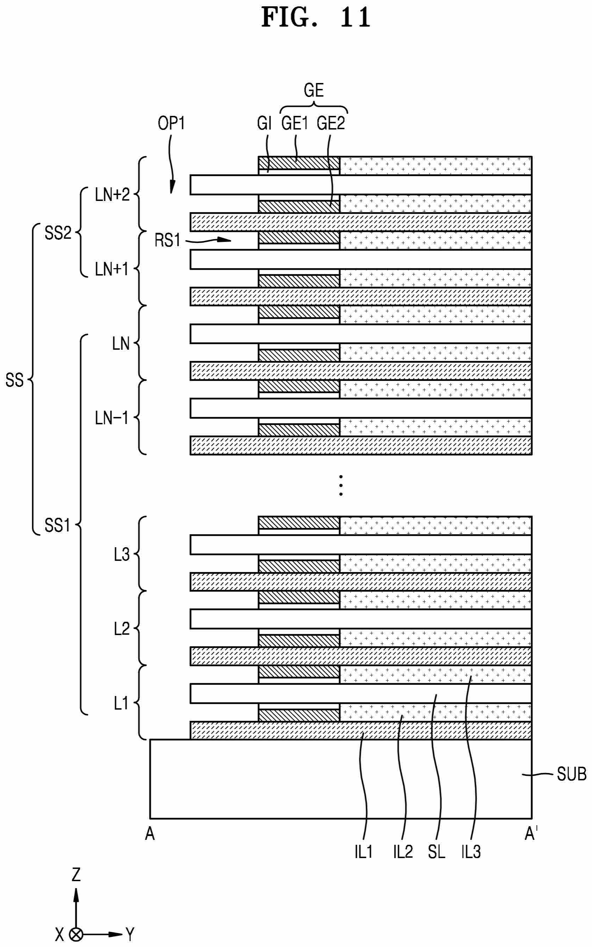

Referring to FIG. 11, a gate insulating pattern GI and a gate electrode GE may be formed within the first recesses RS1.

In an embodiment, the forming of the gate insulating pattern GI and the gate electrode GE within the first recesses RS1 may include forming a gate insulating material layer that may cover the exposed upper surface, lower surface, and the sidewalls of the semiconductor layer SL conformally, forming a gate electrode material layer that may cover the surface of the gate insulating material layer, and recessing the gate insulating material layer and the gate electrode material layer through the first opening OP and the first recesses RS1.

The gate electrode GE may include a first gate electrode GE1 on the upper surface of the semiconductor layer SL and a second gate electrode GE2 on the lower surface of the semiconductor layer SL.

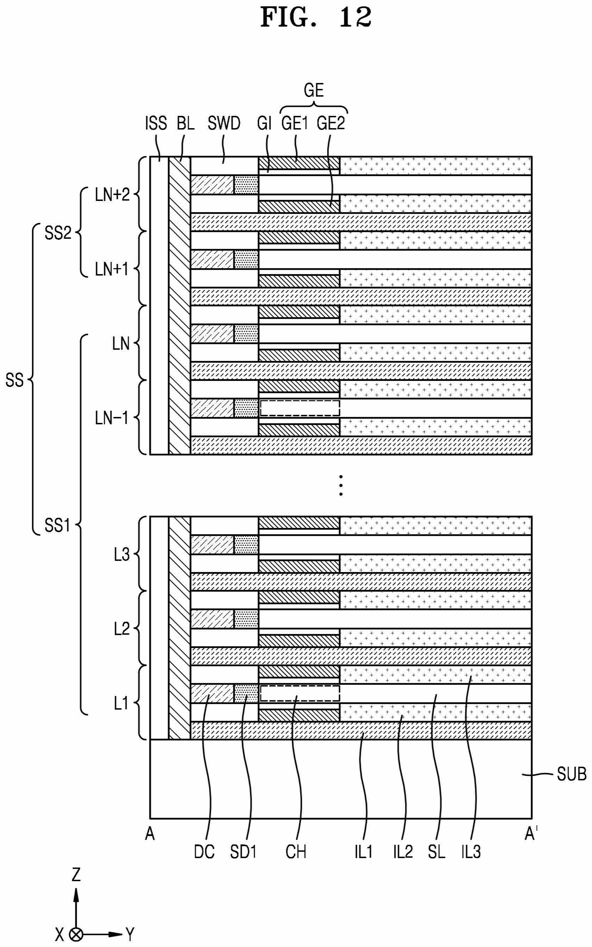

Referring to FIG. 12, a first impurity region SD1, a direct contact DC, bit lines BL, and an insulating structure ISS may be formed.

In an embodiment, the forming of the first impurity region SD1 and the direct contact DC may include performing a GPD process through the first opening OP1 and the first recesses RS1, forming a part of a sidewall insulating pattern SWD at one side of the gate electrode GE, performing silicidation on a part of the semiconductor layer SL, and forming the other part of the sidewall insulating pattern SWD. A part of the semiconductor layer SL that overlaps the gate electrode GE in the vertical direction (e.g., Z direction) may be referred to as a channel region CH.

The GPD process may refer to a process of doping of impurities into the semiconductor material using gas. Since the GPD process uses gas as a doping material, the lattice of semiconductor materials may not be damaged, and the process time may be shortened. The GPD process may adjust variables such as, but not limited to, time, thereby controlling the degree of diffusion.

A part of the sidewall insulating pattern SWD may be arranged on the upper surface and the lower surface of the first impurity region SD1. The first impurity region SD1 may be formed by doping impurities into a part of the semiconductor layer SL. The direct contact DC may include a metal silicide formed by performing silicidation on a part of the semiconductor layer SL.

The direct contact DC may be formed by annealing after a metal layer is deposited on the semiconductor layer SL at one side of the first impurity region SD1. The direct contact DC may be formed by a reaction between the metal layer and the semiconductor layer SL. The first impurity region SD1 and the direct contact DC may be a part of the semiconductor layer SL, however, embodiments of the present disclosure are not limited thereto.

Subsequently, a bit line BL may be formed within the first opening OP1, and an insulating structure ISS may be formed on sidewalls of the bit lines BL.

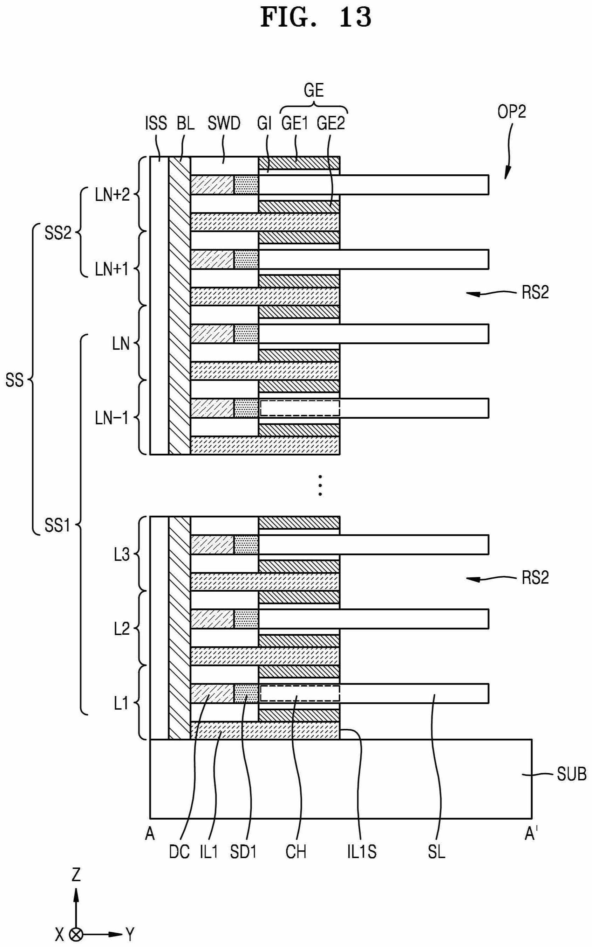

Referring to FIG. 13, a second opening OP2 and second recesses RS2 may be formed.

In an embodiment, a second opening OP2 that penetrates the stack structure SS may be formed. The second opening OP2 may expose the upper surface of the substrate SUB. Subsequently, second recesses RS2 may be formed by etching the first insulating layer IL1, the second insulating layer IL2, and the third insulating layer IL3 at one side of the gate electrode GE. The second recesses RS2 may be formed through a wet etching process using etching selectivity between the first insulating layer IL1, the second insulating layer IL2, the third insulating layer IL3, and the semiconductor layer SL. A space in which the first insulating layer IL1, the second insulating layer IL2 and the third insulating layer IL3 are removed through the wet etching process may form the second recesses RS2.

A part of the semiconductor layer SL may be exposed through the second recesses RS2. The semiconductor layer SL of an upper layer and the semiconductor layer SL of a lower layer may be exposed due to the second recess RS2. Due to the second recess RS2, the semiconductor layer SL may protrude from the outer wall IL1S of the first insulating layer IL1 in the second horizontal direction (e.g., Y direction).

The second recess RS2 may facilitate a gaseous material reaching the exposed surface of the semiconductor layer SL. Due to the second recesses RS2, the outer wall IL1S of the first insulating layer IL1 may be aligned in a line with the outer wall GES of the gate electrode GE.

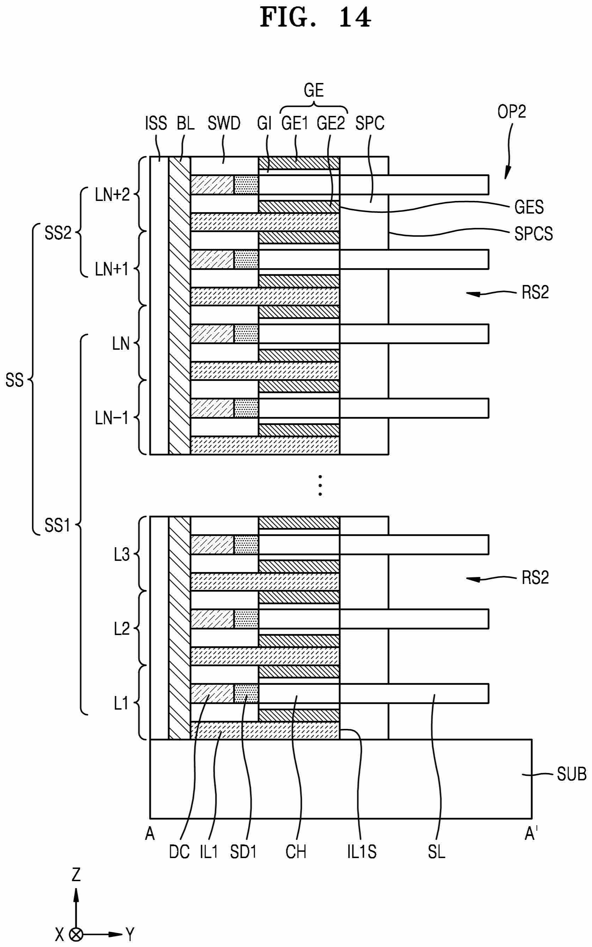

Referring to FIG. 14, the spacer SPC may be formed within the second recess RS2.

In an embodiment, the spacer SPC may formed between the semiconductor layer SL of an upper layer and the semiconductor layer SL of a lower layer. The spacer SPC may be formed on and under the semiconductor layer SL within the second recess RS2. In some embodiments, the spacer SPC may be formed of a silicon nitride (SiN) layer.

The thickness of the spacer SPC in the second horizontal direction (e.g., Y direction) may be freely adjusted. The spacer SPC may be adjacent to one side of the gate electrode GE. The outer wall SPCS of the spacer SPC may be spaced apart from an outer wall GES of the gate electrode GE.

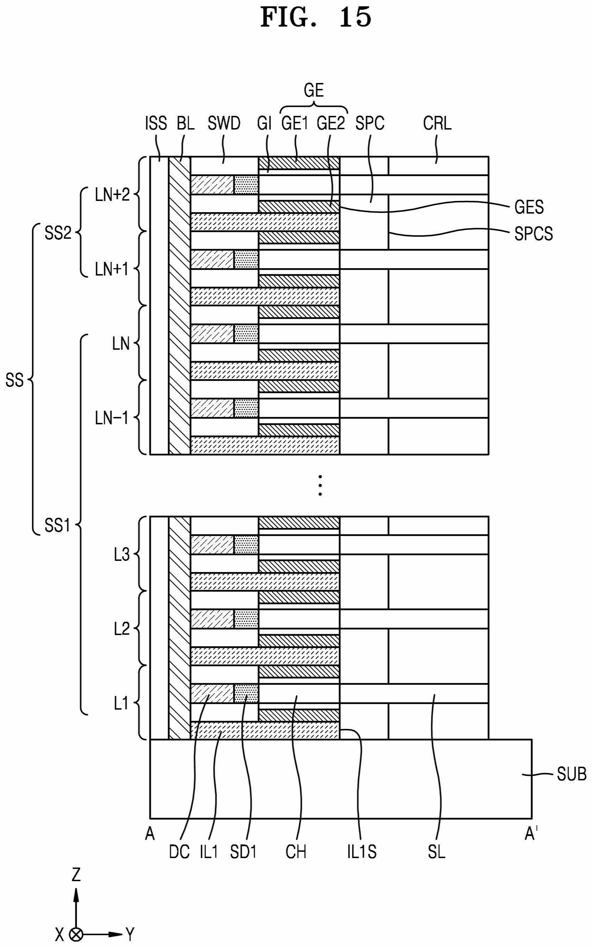

Referring to FIG. 15, a cover insulating layer CRL is formed at one side of the spacer SPC.

In an embodiment, the cover insulating layer CRL may be formed at one side of the spacer SPC and on the semiconductor layer SL. The cover insulating layer CRL may be formed adjacent to the outer wall SPCS of the spacer SPC. In some embodiments, the cover insulating layer CRL may be formed of a material having etching selectivity with the spacer SPC. In some embodiments, the cover insulating layer CRL may be formed of a silicon oxide (SiO) layer.

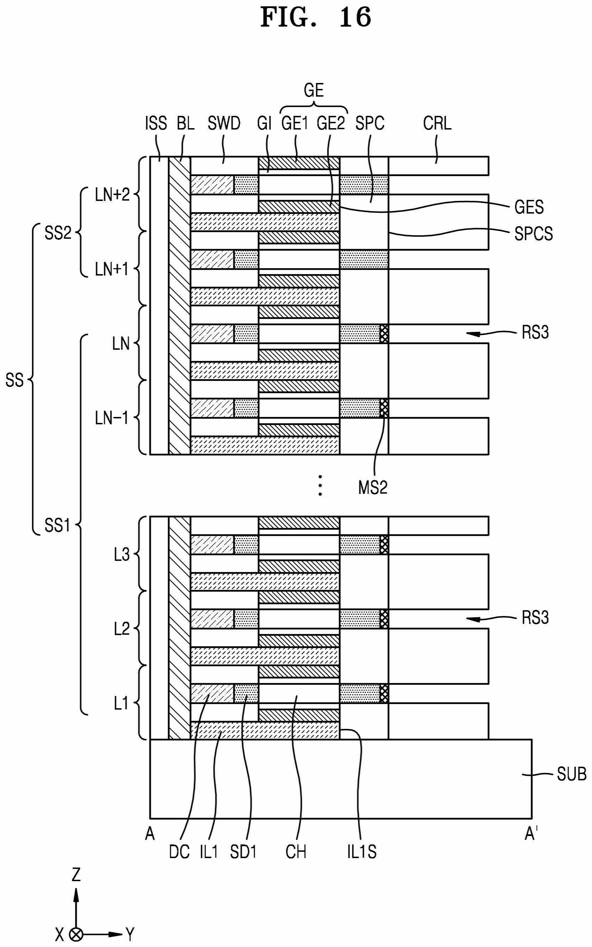

Referring to FIG. 16, a third recess RS3, a second impurity region SD2, and a metal silicide MS2 may be formed. In an embodiment, the semiconductor layer (SL of FIG. 15) arranged between the cover insulating layers CRL in the vertical direction (e.g., Z direction) may be etched to form the third recess RS3 in the second horizontal direction (e.g., Y direction).

A GPD process may be performed through the third recess RS3. Due to the GPD process, impurities may be doped into the exposed portion of the semiconductor layer SL. Thus, the second impurity region SD2 may be formed in the semiconductor layer SL.

In an embodiment, after the semiconductor layer (SL of FIG. 15) is etched to form the third recess RS3 in the second horizontal direction (e.g., Y direction), the second impurity region SD2 may be formed. Alternatively or additionally, after the second impurity region SD2 is formed in the semiconductor layer (SL of FIG. 15) using the GPD process, the spacer SPC, the cover insulating layer CRL, and the third recess RS3 may be formed.

The metal silicide MS2 may be formed at one side of the second impurity region SD2 of the first stack structure SS1. In some embodiments, the metal silicide MS2 may form titanium silicide (TiSi), cobalt silicide (CoSi), molybdenum silicide (MoSi), zirconium silicide (ZrSi), or the like. The metal silicide MS2 may be formed by annealing after a metal layer is deposited onto the semiconductor layer SL at one side of the second impurity region SD2. The metal layer may be formed using a chemical vapor deposition method or an atomic layer deposition method.

The metal silicide MS2 may not be formed at one side of the second impurity region SD2 of the second stack structure SS2, as described below.

In an embodiment, when depositing a metal layer for forming a metal silicide MS2, a metal precursor containing chlorine (Cl) may be used. When chlorine (Cl) is included in the metal precursor, deposition and etching of the metal precursor may occur simultaneously (e.g., at a similar time and/or the same time) when the metal layer is deposited.

Thus, the thickness of the metal layer may not be uniform in the vertical direction (e.g., Z direction) along the second opening OP2. That is, the thickness of the metal layer formed at one side of the second impurity region SD2 in the vertical direction (e.g., Z direction) may not be uniform, and for example, the metal layer may not be formed at one side of the second impurity region SD2 of the second stack structure SS2. In such case, the metal silicide MS2 may not be formed at one side of the second impurity region SD2 of the second stack structure SS2. In one example, where the metal silicide MS2 is not formed at one side of the second impurity region SD2, the second impurity region SD2 is in direct contact with the first electrode EL1.

As shown in FIG. 6, a first electrode EL1 may be formed within the third recess (RE3 of FIG. 16). After the cover insulating layer CRL is removed, a dielectric layer DL that covers the exposed surface of the first electrode EL1 conformally, may be formed. The second electrode EL2 that covers the dielectric layer DL may be formed so that the semiconductor memory device EX1 may be completed.

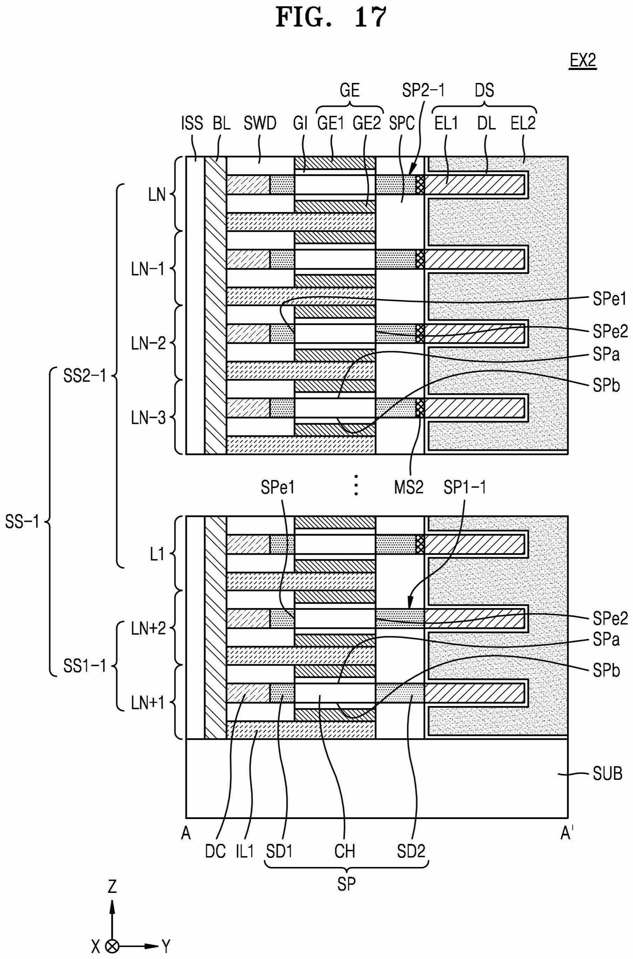

FIG. 17 is a cross-sectional view of a semiconductor memory device, according to an embodiment.

Referring to FIG. 17, a semiconductor memory device EX2 may include and/or may be similar in many respects to the semiconductor memory device EX1 described above with reference to FIGS. 6 to 8, and may include additional features not mentioned above. For example, in the semiconductor memory device EX2, a metal silicide MS2 may not be formed in a first stack structure SS 1-1 of a lower layer on a substrate SUB and the metal silicide MS2 may be formed on a second stack structure SS2-1. In FIG. 17, similar reference numerals as those of FIGS. 6 to 8 may refer to similar or related elements. Consequently, repeated descriptions of the semiconductor memory device EX2 described above with reference to FIGS. 6 to 8 may be briefly described or omitted for the sake of brevity.

The semiconductor memory device EX2 may include the stack structure SS-1 formed on the substrate SUB. The stack structure SS-1 may include the first stack structure SS1-1 formed on the substrate SUB and the second stack structure SS2-1 formed on the first stack structure SS1-1.

The first stack structure SS1-1 may include the (N+1)-th layer LN+1 and the (N+2)-th layer LN+2, which are sequentially stacked on the substrate SUB. The first stack structure SS1-1 may be a dummy stack structure that does not operate as the memory cell (e.g., memory cell MC of FIG. 1).

The first stack structure SS1-1 may be a dummy stack structure in which the metal silicides MS2 are not arranged. The (N+1)-th layer LN+1 and the (N+2)-th layer LN+2, according to an embodiment, may be an example, and additional layers may be stacked on the (N+2)-th layer LN+2.

The second stack structure SS2-1 may include the first to N-th layers L1 to LN, which may be sequentially stacked on the first stack structure SS1-1. The second stack structure SS2-1 may be an active stack structure that operates as the memory cell MC. The second stack structure SS2-1 may be an active stack structure in which the metal silicides MS2 may be arranged.

Each of the (N+1)-th layer LN+1, the (N+2)-th layer LN+2, and the first to N-th layers L1 to LN may include a first insulating layer IL1, a semiconductor pattern SP, a gate electrode GE, a sidewall insulating pattern SWD, and a spacer SPC. The semiconductor patterns SP formed in the first stack structure SS1-1 may include first semiconductor patterns SP1-1.

The semiconductor patterns SP formed in the second stack structure SS2-1 may include a second semiconductor pattern SP2-1. A first stack number of the first semiconductor patterns SP1-1 formed in the first stack structure SS1-1 may be less than a second stack number of the second semiconductor patterns SP2-1 formed in the second stack structure SS2-1.

In some embodiments, the stack number of the first semiconductor patterns SP1-1 and the second semiconductor patterns SP2-1 may range between tens and several hundreds. In some embodiments, the first stack number of the first semiconductor patterns SP1-1 may be 5% to 15% of the second stack number of the second semiconductor patterns SP2-1.

Each of the (N+1)-th layer LN+1, the (N+2)-th layer LN+2, and the first to N-th layers L1 to LN may further include the direct contact DC adjacent to the semiconductor pattern SP and the information storage element DS. The semiconductor pattern SP, the gate electrode GE, and the sidewall insulating pattern SWD may be provided on the first insulating layer IL1. The first insulating layer IL1 may be configured to allow the gate electrode GE of an upper layer and the gate electrode GE of a lower layer to be spaced apart from each other in the vertical direction (e.g., Z direction).

The semiconductor pattern SP may include a channel region CH, a first impurity region SD1, and a second impurity region SD2. The channel region CH may have a first stage SPe1, and a second stage SPe2 facing the first stage SPe1 in the second horizontal direction (e.g., Y direction). The first impurity region SD1 may be arranged at one side of the first stage SPe1, and the second impurity region SD2 may be arranged at one side of the second stage SPe2.

The semiconductor memory device EX2 may include bit lines BL that penetrate the stack structure SS and an insulating structure ISS that covers sidewalls of the bit lines BL. The bit lines BL may be connected to the direct contact DC. The bit lines BL may be electrically connected to the first impurity region SD1 through the direct contact DC.

The information storage element DS may be arranged at one side of the second stage SPe2 of the channel region CH. The information storage element DS may be electrically connected to the second impurity region SD2. Each of the information storage elements DS may include a first electrode EL1, a dielectric layer DL, and a second electrode EL2.

In the first stack structure SS1-1, the metal silicide MS2 may not be arranged between the first electrode EL1 and the second impurity region SD2. In the second stack structure SS2-1, the metal silicide MS2 may be arranged between the first electrode EL1 and the second impurity region SD2. In some embodiments, the metal silicide MS2 may form at least one of titanium silicide (TiSi), cobalt silicide (CoSi), molybdenum silicide (MoSi), zirconium silicide (ZrSi), or the like.

The spacer SPC may be arranged between the second electrode EL2 and the gate electrode GE. The spacer SPC may be arranged between the second impurity region SD2 of an upper layer and the second impurity region SD2 of a lower layer. The spacer SPC may be configured to allow the second impurity region SD2 of the upper layer and the second impurity region SD2 of the lower layer to be spaced apart from each other in the vertical direction (e.g., Z direction).

As described above, in the semiconductor memory device EX2 of the present disclosure, the metal silicide MS2 may not be formed at one side of the first semiconductor patterns SP1-1 of a lower layer among the semiconductor patterns SP that constitute the stack structure SS-1 vertically stacked on the substrate SUB. Furthermore, in the semiconductor memory device EX2 of the present disclosure, the metal silicide MS2 may be formed at one side of the second semiconductor patterns SP2-1 of an upper layer among the semiconductor patterns SP that constitute the stack structure SS-1 vertically stacked on the substrate SUB.

That is, in the semiconductor memory device EX2 of the present disclosure, the metal silicide MS2 may not be formed between the second impurity region SD2 (e.g., a second source/drain) at one side of the first semiconductor patterns SP1-1 of a lower layer among the semiconductor patterns SP that constitute the stack structure SS-1, and the information storage element DS (e.g., a capacitor). Furthermore, in the semiconductor memory device EX2 of the present disclosure, the metal silicide MS2 may be formed between the second impurity region SD2 (e.g., a second source/drain) at one side of the second semiconductor patterns SP2-1 of an upper layer among the semiconductor patterns SP that constitute the stack structure SS-1, and the information storage element DS (e.g., a capacitor).

In the semiconductor memory device EX2 of the present disclosure, the metal silicide MS2 may be formed only at one side of the second semiconductor patterns SP2-1 of an upper layer among the semiconductor patterns SP that constitute the stack structure SS-1, so that distribution of contact resistances between the second semiconductor patterns SP2-1 in the vertical direction (e.g., Z direction) during a manufacturing process may be reduced. Thus, in the semiconductor memory device EX2 of the present disclosure, distribution of contact resistances between memory cells may be reduced, so that electrical characteristics of the semiconductor memory device EX2 may be enhanced, when compared to a related semiconductor memory device. Ine one example, one of the first stack structure and the second stack structure comprises metal silicides disposed between the second impurity regions at a side of the semiconductor patterns and the first electrodes.

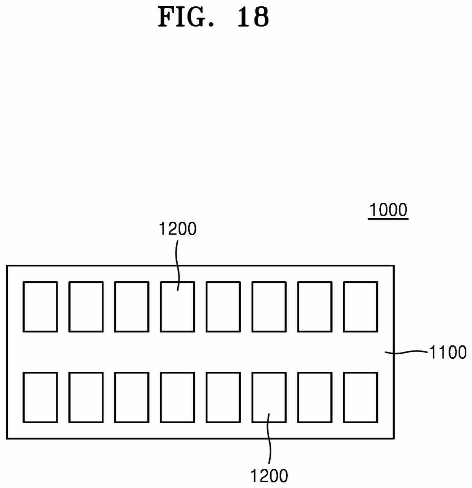

FIG. 18 is a plan view of a memory module including a semiconductor memory device, according to an embodiment.

Referring to FIG. 18, a memory module 1000 may include a printed circuit board 1100 and a plurality of semiconductor packages 1200. The plurality of semiconductor packages 1200 may include semiconductor memory devices EX1 and EX2, according to embodiments.

The memory module 1000 may be and/or may include a single in-lined memory module (SIMM) in which the plurality of semiconductor packages 1200 are mounted only on one surface of the printed circuit board 1100, and/or a dual in-lined memory module (DIMM) in which the plurality of semiconductor packages 1200 are arranged on both surfaces of the printed circuit board 1100. In addition, the memory module 1000 may be a fully buffered DIMM (FBDIMM) having an advanced memory buffer (AMB) for providing signals from the outside to the plurality of semiconductor packages 1200, respectively.

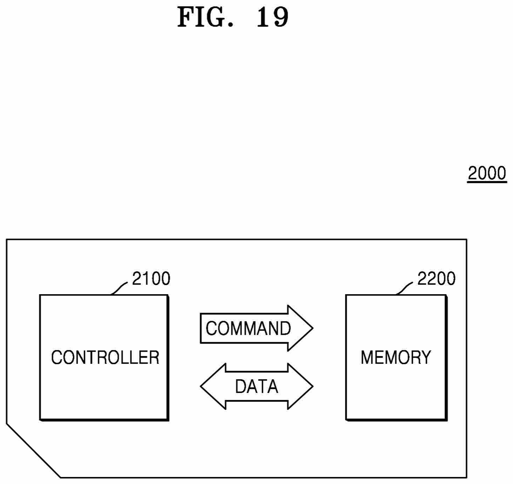

FIG. 19 is a schematic diagram of a memory card including a semiconductor device, according to an embodiment.

Referring to FIG. 19, the memory card 2000 may be arranged such that a controller 2100 and memory 2200 may exchange electrical signals. For example, when a command is given from the controller 2100, the memory 2200 may transmit data in response to the command from the controller 2100.

The controller 2100 may include the semiconductor device of the present disclosure. The memory 2200 may include semiconductor memory devices EX1 and EX2 of the present disclosure. The memory card 2000 may be implemented as at least one of various types of cards such as, but not limited to, a memory stick card, a smart media card (SM), a secure digital card (SD), or a mini-secured digital card, and/or various memory cards such as, but not limited to, multimedia card (MMC), or the like.

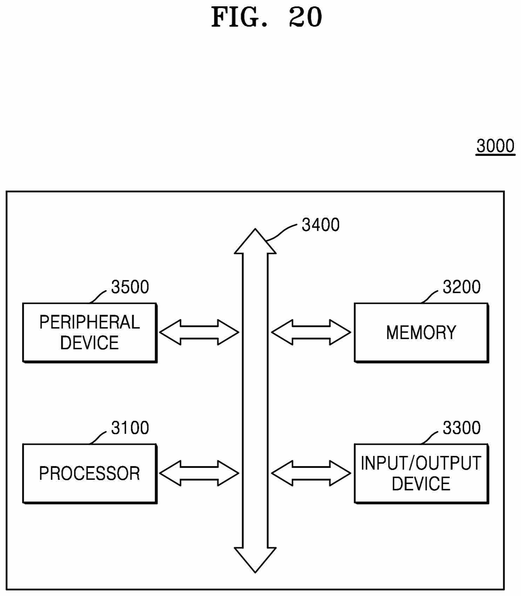

FIG. 20 is a schematic diagram of a system including a semiconductor memory device, according to an embodiment.

Referring to FIG. 20, in a system 3000, a processor 3100, memory 3200, and an input/output device 3300 may communicate data mutually using a bus 3400. The memory 3200 of the system 3000 may be and/or may include random access memory (RAM) and/or read only memory (ROM). In addition, the system 3000 may include a peripheral device 3500 such as, but not limited to, a floppy disk drive (FDD), a compact disk (CD) ROM (CD-ROM) drive, or the like.

The memory 3200 may include semiconductor memory devices EX1 and EX2 of the present disclosure. The memory 3200 may store a code and data for the operation of the processor 3100. The system 3000 may be and/or may include at least one of a mobile phone, a Moving Picture Experts Group (MPEG) Audio Layer 3 (MP3) player, a navigation device (e.g., a global positioning system (GPS)), a portable multimedia player (PMP), a solid state disk (SSD), a household appliance, or the like.

Embodiments are set out in the following clauses:
Clause 1. A semiconductor memory device, comprising: a stack structure comprising a plurality of layers stacked on a substrate in a vertical direction, the stack structure comprising a first stack structure on the substrate and a second stack structure on the first stack structure; and bit lines disposed at a side of the stack structure and extending in the vertical direction, wherein the plurality of layers comprise: semiconductor patterns; gate electrodes extending from the semiconductor patterns in a first horizontal direction; and information storage elements adjacent to the semiconductor patterns in a second horizontal direction crossing the first horizontal direction, wherein the semiconductor patterns comprise: first impurity regions adjacent to the bit lines; second impurity regions adjacent to the information storage elements; and channel regions between the first impurity regions and the second impurity regions, wherein the information storage elements comprise first electrodes adjacent to the second impurity regions, and wherein one of the first stack structure and the second stack structure comprises metal silicides disposed between the second impurity regions at a side of the semiconductor patterns and the first electrodes.
Clause 2. The semiconductor memory device of Clause 1, wherein a stack structure in which the metal silicides are disposed, from among the first stack structure and the second stack structure,
comprises an active stack structure, and wherein a stack structure in which the metal silicides are not disposed, from among the first stack structure and the second stack structure, comprises a dummy stack structure.
Clause 3. The semiconductor memory device of Clause 1 or 2, wherein the first stack structure comprises first semiconductor patterns, wherein the second stack structure comprises second semiconductor patterns, and wherein a second stack number of the second semiconductor patterns is less than a first stack number of the first semiconductor patterns.
Clause 4. The semiconductor memory device of Clause 3, wherein the second stack number is 5% to 15% of the first stack number.
Clause 5. The semiconductor memory device of Clause 1 or 2, wherein the first stack structure comprises first semiconductor patterns, wherein the second stack structure comprises second semiconductor patterns, and wherein a first stack number of the first semiconductor patterns is less than a second stack number of the second semiconductor patterns.
Clause 6. The semiconductor memory device of Clause 5, wherein the first stack number is 5% to 15% of the second stack number.
Clause 7. The semiconductor memory device of any preceding Clause, further comprising: spacers disposed at a side of the gate electrodes in the second horizontal direction, disposed between the second impurity regions in the vertical direction, and extending in the first horizontal direction.
Clause 8. The semiconductor memory device of Clause 7, wherein outer walls of some of the second impurity regions are aligned with outer walls of the spacers in the vertical direction.
Clause 9. The semiconductor memory device of Clause 7 or 8, wherein outer walls of the metal silicides are aligned with outer walls of the spacers in the vertical direction.
Clause 10. The semiconductor memory device of any preceding Clause, wherein the plurality of layers further comprise insulating layers under the gate electrodes, and wherein outer walls of the insulating layers are aligned with outer walls of the gate electrodes in the vertical direction.
Clause 11. A semiconductor memory device, comprising: a stack structure comprising a plurality of layers stacked on a substrate in a vertical direction, the stack structure comprising a first stack structure on the substrate and a second stack structure on the first stack structure; and bit lines disposed at one side of the stack structure and extending in the vertical direction, wherein the plurality of layers comprise: semiconductor patterns; gate electrodes extending from the semiconductor patterns in a first horizontal direction; and information storage elements adjacent to the semiconductor patterns in a second horizontal direction crossing the first horizontal direction, wherein the semiconductor patterns comprise: first impurity regions adjacent to the bit lines; second impurity regions adjacent to the information storage elements; and channel regions between the first impurity regions and the second impurity regions, wherein the information storage elements comprise first electrodes adjacent to the second impurity regions, wherein the first stack structure comprises an active stack structure comprising metal silicides disposed between the second impurity regions at one side of the semiconductor patterns and the first electrodes, and wherein the second stack structure comprises a dummy stack structure in which the metal silicides are not disposed.
Clause 12. The semiconductor memory device of Clause 11, wherein the first stack structure comprises first semiconductor patterns, wherein the second stack structure comprises second semiconductor patterns, and wherein a second stack number of the second semiconductor patterns is less than a first stack number of the first semiconductor patterns.
Clause 13. The semiconductor memory device of Clause 11 or 12, further comprising: spacers disposed at a side of the gate electrodes in the second horizontal direction, disposed between the second impurity regions in the vertical direction,and extending in the first horizontal direction, wherein outer walls of the second impurity regions of the second stack structure are aligned with outer walls of the spacers in the vertical direction, and wherein outer walls of the metal silicides of the first stack structure are aligned with outer walls of the spacers in the vertical direction.
Clause 14. The semiconductor memory device of Clause 11, 12 or 13, wherein the plurality of layers further comprise insulating layers disposed under the gate electrodes, and wherein outer walls of the insulating layers are aligned with outer walls of the gate electrodes in the vertical direction.
Clause 15. A semiconductor memory device, comprising: a stack structure comprising a plurality of layers stacked on a substrate in a vertical direction, the stack structure comprising a first stack structure on the substrate and a second stack structure on the first stack structure; bit lines disposed at one side of the stack structure and extending in the vertical direction; and spacers extending in a first horizontal direction, wherein the plurality of layers comprise: semiconductor patterns; gate electrodes extending from the semiconductor patterns in the first horizontal direction; and information storage elements adjacent to the semiconductor patterns in a second horizontal direction crossing the first horizontal direction, wherein the semiconductor patterns comprise: first impurity regions adjacent to the bit lines; second impurity regions adjacent to the information storage elements; and channel regions between the first impurity regions and the second impurity regions, wherein the information storage elements comprise first electrodes adjacent to the second impurity regions, wherein the spacers are disposed at a side of the gate electrodes in the second horizontal direction and disposed between the second impurity regions in the vertical direction, wherein the first stack structure comprises a dummy stack structure in which metal silicides are not disposed, and wherein the second stack structure comprises an active stack structure comprising metal silicides disposed between the second impurity regions at a side of the semiconductor patterns and the first electrodes.

While the present disclosure has been particularly shown and described with reference to embodiments thereof, it is to be understood that various changes in form and details may be made therein without departing from the scope of the following claims.

## Claims

1. A semiconductor memory device (EX1; EX2), comprising:
a stack structure (SS) comprising a plurality of layers (L1-LN+2) stacked on a substrate (SUB) in a vertical direction (Z), the stack structure (SS) comprising a first stack structure (SS1) on the substrate (SUB) and a second stack structure (SS2) on the first stack structure (SS1); and
bit lines (BL) disposed at a side of the stack structure (SS) and extending in the vertical direction (Z),
wherein the plurality of layers comprise (L1-LN+2):
semiconductor patterns (SP);
gate electrodes (GE) extending from the semiconductor patterns (SP) in a first horizontal direction (X); and
information storage elements (DS) adjacent to the semiconductor patterns (SP) in a second horizontal direction (Y) crossing the first horizontal direction (X),
wherein the semiconductor patterns (SP) comprise:
first impurity regions (SD1) adjacent to the bit lines (BL);
second impurity regions (SD2) adjacent to the information storage elements (DS); and
channel regions (CH) between the first impurity regions (SD1) and the second impurity regions (SD2),
wherein the information storage elements (DS) comprise first electrodes (EL1) adjacent to the second impurity regions (SD2), and
wherein one of the first stack structure (SS1) and the second stack structure (SS2) comprises metal silicides (MS2) disposed between the second impurity regions (SD2) at a side of the semiconductor patterns (SP) and the first electrodes (EL1).

2. The semiconductor memory device of claim 1, wherein a stack structure (SS) in which the metal silicides (MS2) are disposed, from among the first stack structure (SS1) and the second stack structure (SS2), comprises an active stack structure, and
wherein a stack structure (SS) in which the metal silicides (MS2) are not disposed, from among the first stack structure (SS1) and the second stack structure (SS2), comprises a dummy stack structure.

3. The semiconductor memory device of claim 1 or 2, wherein the first stack structure (SS1) comprises first semiconductor patterns (SP1),
wherein the second stack structure (SS2) comprises second semiconductor patterns (SP2), and
wherein a second stack number of the second semiconductor patterns (SP2) is less than a first stack number of the first semiconductor patterns (SP1).

4. The semiconductor memory device of claim 3, wherein the second stack number is 5% to 15% of the first stack number.

5. The semiconductor memory device of claim 1 or 2, wherein the first stack structure (SS1) comprises first semiconductor patterns (SP1),
wherein the second stack structure (SS2) comprises second semiconductor patterns (SP2), and
wherein a first stack number of the first semiconductor patterns (SP1) is less than a second stack number of the second semiconductor patterns (SP2).

6. The semiconductor memory device of claim 5, wherein the first stack number is 5% to 15% of the second stack number.

7. The semiconductor memory device of any preceding claim, further comprising:
spacers (SPC) disposed at a side of the gate electrodes (GE) in the second horizontal direction (Y), disposed between the second impurity regions (SD2) in the vertical direction (Z), and extending in the first horizontal direction (X).

8. The semiconductor memory device of claim 7, wherein outer walls (SD2S) of some of the second impurity regions (SD2) are aligned with outer walls (SPCS) of the spacers (SPC) in the vertical direction (Z).

9. The semiconductor memory device of claim 7 or 8, wherein outer walls (MS2S) of the metal silicides (MS2) are aligned with outer walls (SPCS) of the spacers in the vertical direction (Z).

10. The semiconductor memory device of any preceding claim, wherein the plurality of layers (L1-LN+2) further comprise insulating layers (IL1) under the gate electrodes (GE), and
wherein outer walls (IL1S) of the insulating layers (IL1) are aligned with outer walls (GES) of the gate electrodes (GE) in the vertical direction (Z).

11. The semiconductor memory device of claim 1,
wherein the first stack structure (SS1) comprises an active stack structure comprising the metal silicides (MS2), and
wherein the second stack structure (SS2) comprises a dummy stack structure in which the metal silicides (MS2) are not disposed.

12. The semiconductor memory device of claim 11, wherein the first stack structure (SS1) comprises first semiconductor patterns (SP1),
wherein the second stack structure (SS2) comprises second semiconductor patterns (SP2), and
wherein a second stack number (SS2) of the second semiconductor patterns (SP2) is less than a first stack number of the first semiconductor patterns (SP1).

13. The semiconductor memory device of claim 11 or 12, further comprising:
spacers (SPC) disposed at a side of the gate electrodes (GE) in the second horizontal direction (Y), disposed between the second impurity regions (SD2) in the vertical direction (Z), and extending in the first horizontal direction (X),
wherein outer walls (SD2S) of the second impurity regions (SD2) of the second stack structure (SS2) are aligned with outer walls (SPCS) of the spacers (SPC) in the vertical direction (Z), and
wherein outer walls (MS2S) of the metal silicides (MS2) of the first stack structure (SS1) are aligned with outer walls (SPCS) of the spacers (SPC) in the vertical direction (Z).

14. The semiconductor memory device of claim 11, 12 or 13, wherein the plurality of layers (L1-LN+2) further comprise insulating layers (IL1) disposed under the gate electrodes (GE), and
wherein outer walls (IL1S) of the insulating layers (IL1) are aligned with outer walls (GES) of the gate electrodes (GE) in the vertical direction (Z).

15. The semiconductor memory device of claim 1, comprising:
spacers (SPC) extending in a first horizontal direction (X),
wherein the spacers (SPC) are disposed at a side of the gate electrodes (GE) in the second horizontal direction (Y) and disposed between the second impurity regions (SD2) in the vertical direction (Z),
wherein the first stack structure (SS1) comprises a dummy stack structure in which the metal silicides (MS2) are not disposed, and
wherein the second stack structure (SS2) comprises an active stack structure comprising the metal silicides (MS2) disposed between the second impurity regions (SD2) at a side of the semiconductor patterns (SP) and the first electrodes (EL1).
